# EUROPÄISCHE PATENTSCHRIFT

(11) **EP 0 779 905 B1**
(45) Veröffentlichungstag und Bekanntmachung des Hinweises auf die Patenterteilung: **10.06.1998**
(21) Anmeldenummer: 95928984.4
(22) Anmeldetag: 25.08.1995
(51) Int. Cl.: C08G 59/30, C08G 59/40, C08G 59/52, C08G 59/54, H01L 23/29

(54) **EPOXIDHARZMISCHUNGEN FÜR PREPREGS UND VERBUNDWERKSTOFFE**
EPOXY RESIN MIXTURES FOR PREPREGS AND COMPOSITES
MELANGES DE RESINES EPOXY POUR PREIMPREGNES ET MATERIAUX COMPOSITES

(30) Priorität: 09.09.1994 DE 4432189
(43) Veröffentlichungstag der Anmeldung: 25.06.1997
(73) Patentinhaber: SIEMENS AKTIENGESELLSCHAFT, 80333 München (DE)
(72) Erfinder: VON GENTZKOW, Wolfgang, D-91077 Kleinsendelbach (DE); HUBER, Jürgen, D-91058 Erlangen (DE); KAPITZA, Heinrich, D-90765 Fürth (DE); ROGLER, Wolfgang, D-91096 Möhrendorf (DE); SCHÖNAMSGRUBER, Uwe, D-90431 Nürnberg (DE)
(86) Internationale Anmeldenummer: DE9501136
(87) Internationale Veröffentlichungsnummer: WO9607685

(56) Entgegenhaltungen:
- US-A- 3 741 858
- US-A- 4 111 909
- DATABASE WPI Derwent Publications Ltd., London, GB; AN 89-184043 & JP,A,01 123 892 (DAIICHI KOGYO EIYAKU) , 16.Mai 1989

## Beschreibung

Die Erfindung betrifft Epoxidharzmischungen zur Herstellung von Prepregs und Verbundwerkstoffen sowie aus diesen Epoxidharzmischungen hergestellte Prepregs und Verbundwerkstoffe.

Verbundwerkstoffe auf der Basis von Epoxidharzen und anorganischen oder organischen Verstärkungsmaterialien haben in vielen Bereichen der Technik und des täglichen Lebens eine hohe Bedeutung erlangt. Gründe dafür sind einerseits die relativ einfache und sichere Verarbeitung der Epoxidharze und andererseits das gute mechanische und chemische Eigenschaftsniveau der gehärteten Epoxidharz-Formstoffe, das eine Anpassung an unterschiedliche Einsatzzwecke und eine vorteilhafte Nutzung der Eigenschaften aller am Verbund beteiligten Werkstoffe gestattet.

Die Verarbeitung der Epoxidharze zu Verbundwerkstoffen erfolgt vorteilhaft über die Herstellung von Prepregs. Zu diesem Zweck werden anorganische oder organische Verstärkungsmaterialien bzw. Einlagerungskomponenten in Form von Fasern, Vliesen und Geweben oder von Flachenstoffen mit dem Harz getränkt. In den meisten Fällen geschieht dies mit einer Lösung des Harzes in einem leicht verdampf- oder verflüchtigbaren Lösungsmittel. Die dabei erhaltenen Prepregs dürfen nach diesem Prozeß nicht mehr klebend, aber auch noch nicht ausgehärtet sein, vielmehr soll sich die Harzmatrix lediglich in einem vorpolymerisierten Zustand befinden. Außerdem müssen die Prepregs ausreichend lagerstabil sein. So wird beispielsweise für die Herstellung von Leiterplatten eine Lagerstabilität von mindestens drei Monaten gefordert. Bei der Weiterverarbeitung zu Verbundwerkstoffen müssen die Prepregs außerdem bei Temperaturerhöhung aufschmelzen und sich mit den Verstärkungsmaterialien bzw. Einlagerungskomponenten sowie mit den für den Verbund vorgesehenen Werkstoffen unter Druck möglichst fest und dauerhaft verbinden, d.h. die vernetzte Epoxidharzmatrix muß eine hohe Grenzflächenhaftung zu den Verstärkungsmaterialien bzw. Einlagerungskomponenten sowie zu den zu verbindenden Materialien, wie metallischen, keramischen, mineralischen und organischen Materialien, ausbilden.

Im gehärteten Zustand wird von den Verbundwerkstoffen generell hohe mechanische und thermische Festigkeit sowie chemische Beständigkeit und Wärmeformbeständigkeit bzw. Alterungsbeständigkeit gefordert. Für elektrotechnische und elektronische Anwendungen kommt die Forderung nach dauerhaft hohen elektrischen Isolationseigenschaften und für spezielle Einsatzzwecke eine Vielzahl von zusätzlichen Forderungen hinzu. Für den Einsatz als Leiterplattenmaterial sind beispielsweise hohe Dimensionsstabilität über einen weiten Temperaturbereich, gutes Haftvermögen zu Glas und Kupfer, hoher Oberflächenwiderstand, geringer dielektrischer Verlustfaktor, gutes Bearbeitungsverhalten (Stanzbarkeit, Bohrbarkeit), geringe Wasseraufnahme und hohe Korrosionsbeständigkeit erforderlich.

Eine Forderung, die in letzter Zeit zunehmende Bedeutung erlangt, ist die Forderung nach Schwerbrennbarkeit. In vielen Bereichen kommt dieser Forderung - wegen der Gefährdung von Menschen und Sachwerten - erste Priorität zu, beispielsweise bei Konstruktionswerkstoffen für den Flugzeug- und Kraftfahrzeugbau und für öffentliche Verkehrsmittel. Bei den elektrotechnischen und insbesondere den elektronischen Anwendungen ist die Schwerbrennbarkeit von Leiterplattenmaterialien - wegen des hohen Wertes der darauf montierten elektronischen Bauelemente - unverzichtbar.

Zur Beurteilung des Brennverhaltens muß deshalb eine der härtesten Materialprüfungen bestanden werden, nämlich die V-0-Einstufung nach UL 94 V. Bei dieser Prüfung wird ein Prüfkörper vertikal am unteren Rand mit einer definierten Flamme beflammt. Die Summe der Brennzeiten von zehn Prüfungen darf 50 s nicht überschreiten. Diese Forderung ist schwer zu erfüllen, vor allem dann, wenn dünne Wandstärken vorliegen, wie dies in der Elektronik der Fall ist. Das weltweit im technischen Einsatz für FR4-Laminate befindliche Epoxidharz erfüllt diese Forderungen nur, weil es - auf das Harz bezogen - ca. 30 bis 40 % kernbromierte aromatische Epoxid-Komponenten enthält, d.h. ca. 17 bis 21 % Brom. Für andere Einsatzzwecke werden vergleichbar hohe Konzentrationen an Halogenverbindungen eingesetzt und oft noch mit Antimontrioxid als Synergist kombiniert. Die Problematik bei diesen Verbindungen besteht darin, daß sie einerseits zwar hervorragend als Flammschutzmittel wirksam sind, andererseits aber auch sehr bedenkliche Eigenschaften besitzen. So steht Antimontrioxid auf der Liste der krebserzeugenden Chemikalien, und aromatische Bromverbindungen spalten bei der thermischen Zersetzung nicht nur Bromradikale und Bromwasserstoff ab, die zu starker Korrosion führen, vielmehr können bei der Zersetzung in Gegenwart von Sauerstoff insbesondere die hochbromierten Aromaten auch die hochtoxischen Polybromdibenzofurane und Polybromdibenzodioxine bilden. Erhebliche Schwierigkeiten bereitet ferner die Entsorgung von bromhaltigen Altwerkstoffen und Giftmüll.

Aus diesen Gründen hat es nicht an Versuchen gefehlt, die bromhaltigen Flammschutzmittel durch weniger problematische Substanzen zu ersetzen. So wurden beispielsweise Füllstoffe mit Löschgaswirkung, wie Aluminiumoxidhydrate (siehe: "J. Fire and Flammability", Vol. 3 (1972), Seiten 51 ff.), basische Aluminiumcarbonate (siehe: "Plast. Engng.", Vol. 32 (1976), Seiten 41 ff.) und Magnesiumhydroxide (EP-OS 0 243 201), sowie verglasende Füllstoffe, wie Borate (siehe: "Modern Plastics", Vol. 47 (1970), No. 6, Seiten 140 ff.) und Phosphate (US-PS 2 766 139 und US-PS 3 398 019), vorgeschlagen. Allen diesen Füllstoffen haftet aber der Nachteil an, daß sie die mechanischen, chemischen und elektrischen Eigenschaften der Verbundwerkstoffe zum Teil erheblich verschlechtern. Außerdem erfordern sie spezielle, meist aufwendigere Verarbeitungstechniken, da sie zur Sedimentation neigen und die Viskosität des gefüllten Harzsystems erhöhen.

Es ist auch schon die flammhemmende Wirksamkeit von rotem Phosphor beschrieben worden (GB-PS 1 112 139), gegebenenfalls in Kombination mit feinstverteiltem Siliciumdioxid oder Aluminiumoxidhydrat (US-PS 3 373 135). Dabei werden Werkstoffe erhalten, deren Einsatz für elektrotechnische und elektronische Zwecke - wegen der in Gegenwart von Feuchtigkeit entstehenden Phosphorsäure und der damit verbundenen Korrosion - eingeschränkt ist. Ferner wurden bereits organische Phosphorverbindungen, wie Phosphorsäureester, Phosphonsäureester und Phosphine als flammhemmende Additive vorgeschlagen (siehe: W.C. Kuryla und A.J. Papa "Flame Retardancy of Polymeric Materials", Vol. 1, Marcel Dekker Inc., New York, 1973, Seiten 24 bis 38 und 52 bis 61). Da diese Verbindungen für ihre "weichmachenden" Eigenschaften bekannt sind und deshalb auch als Weichmacher für Polymere weltweit in großem Maßstab verwendet werden (GB-PS 10 794), ist diese Alternative ebenfalls wenig erfolgversprechend.

Um eine Flammwidrigkeit nach UL 94 V-0 zu erreichen, ist es aus der DE-OS 38 36 409 bekannt, Prepregs in der Weise herzustellen, daß bestimmte Verstärkungsmaterialien oder Flächenstoffe mit einer Suspension von halogenfreien, Stickstoff und Phosphor enthaltenden Flammschutzmitteln in einer Lösung aus aromatischen, heterocyclischen und/oder cycloaliphatischen Epoxidharzen (in nicht-kernhalogenierter oder in kernhalogenierter Form mit niedrigem Halogengehalt) und aromatischen Polyaminen und/oder aliphatischen Amiden als Härter imprägniert werden. Die Flammschutzmittel sind dabei halogenfreie Melaminharze oder organische Phosphorsäureester, insbesondere Melamincyanurate, Melaminphosphate, Triphenylphosphat und Diphenylkresylphosphat sowie deren Gemische. Auch dies ist aber eine wenig erfolgversprechende Lösung, weil die verwendeten Füllstoffe stets die Wasseraufnahme erhöhen und deshalb leiterplattenspezifische Prüfungen nicht mehr bestanden werden.

Zur flammhemmenden Einstellung von Epoxidharzen können auch organische Phosphorverbindungen, wie epoxidgruppenhaltige Phosphorverbindungen, dienen, die im Epoxidharznetzwerk verankerbar sind. So sind aus der EP-PS 0 384 940 Epoxidharzmischungen bekannt, die kommerziell erhältliches Epoxidharz, das aromatische Polyamin 1,3,5-Tris(3-amino-4-alkylphenyl)-2,4,6-trioxo-hexahydrotriazin und eine epoxidgruppenhaltige Phosphorverbindung auf der Basis von Glycidylphosphat, Glycidylphosphonat oder Glycidylphosphinat enthalten. Mit derartigen Epoxidharzmischungen lassen sich - ohne Halogenzusatz - schwerbrennbare, nach UL 94 V-0 einstufbare Laminate bzw. Verbundwerkstoffe herstellen, die eine Glasübergangstemperatur von > 200°C aufweisen. Zudem lassen sich diese Epoxidharzmischungen vergleichbar mit den im Einsatz befindlichen Epoxidharzen verarbeiten.

Leiterplatten sind die Basis für die Herstellung von elektronischen Flachbaugruppen. Sie dienen dazu, die verschiedensten elektronischen und mikroelektronischen Bauelemente miteinander zu elektronischen Schaltungen zu verbinden. Dabei werden die Bauelemente - mittels komplexer, hochautomatisierter Bestückungsprozesse - durch Verkleben oder Löten mit der Leiterplatte verbunden. Auch bei der Flachbaugruppenbestückung besteht der Trend zu immer rationelleren Fertigungsmethoden. Daher wird in der SMD-Technik vermehrt das IR-Reflow-Löten angewendet, das in der Zukunft die anderen Lötverfahren weitgehend ersetzen wird. Bei diesem Verfahren wird die gesamte Leiterplatte durch IR-Bestrahlung innerhalb von wenigen Sekunden auf Temperaturen > 260°C aufgeheizt; in der Leiterplatte absorbiertes Wasser wird dabei schlagartig verdampft. Nur Laminate mit sehr guter interlaminarer Haftung überstehen IR-Lötprozesse ohne Zerstörung durch Delamination. Zur Verminderung dieser Gefahr wurden aufwendige Konditionierungsprozesse vorgeschlagen (siehe dazu: "Galvanotechnik", Bd. 84 (1993), Seiten 3865 bis 3870).

Kritisch sind in dieser Hinsicht vor allem die sogenannten Multilayer-Leiterplatten (ML), die einen Großteil der heutzutage hergestellten Leiterplatten ausmachen. Diese Leiterplatten enthalten eine Vielzahl von Leiterebenen, die durch Epoxidharzverbünde gegeneinander distanziert und isoliert sind. Der Trend in der ML-Technik geht nun aber zu einer immer höheren Anzahl von Leiterebenen; so werden derzeit Multilayer-Leiterplatten mit mehr als 20 Leiterebenen gefertigt. Da eine zu hohe Gesamtdicke dieser Leiterplatten aus technischen Gründen vermieden werden muß, wird der Abstand zwischen den Leiterebenen immer geringer und damit die interlaminare Haftung und die Kupfer-Haftung bei ML-Laminaten immer problematischer. Beim IR-Löten werden an diesen Typ von Leiterplatten außerdem besonders hohe Anforderungen hinsichtlich der Lötbadbeständigkeit gestellt.

Aus der EP-PS 0 384 940 ist es - wie bereits ausgeführt - bekannt, daß sich durch Phosphormodifizierung von Imprägnierharzen Laminate mit einer anforderungsgemäßen Flammwidrigkeit ohne Halogen herstellen lassen. Bei Fertigungsversuchen hat sich jedoch gezeigt, daß bei phosphormodifizierten Laminaten die Gefahr einer Delamination beim IR-Löten besteht. Es ergibt sich daher ein dringender Bedarf an Elektrolaminaten, bei denen einerseits die geforderte Flammwidrigkeit halogenfrei, beispielsweise durch Einbau von Phosphor in die Harzmatrix, erreicht wird, die andererseits aber für das in der SMD-Technik eingeführte IR-Löten geeignet sind. Dafür werden Elektrolaminate mit extrem hoher Lötbadbeständigkeit benötigt.

In der Leiterplattentechnik werden vor allem der High-Pressure-Cooker-Test (HPCT) und die Bestimmung der sogenannten Lötbadbeständigkeit benutzt, um die Eignung von Laminaten für eine hohe thermische Belastbarkeit zu prüfen. Beim HPCT wird eine vom Kupfer befreite Laminatprobe (5 x 5 cm) bei 120°C und ca. 1,4 bar Wasserdampfdruck 2 h belastet und anschließend in einem 260°C heißen Lötbad schwimmend gelagert, wobei die Zeit bis zur Delaminierung gemessen wird. Qualitativ gute Laminate zeigen dabei bis > 20 s keine Delaminierung. Die Lötbadbeständigkeit wird an 2 x 10 cm großen Laminatproben bestimmt, indem diese in ein 288°C heißes Lötbad getaucht werden und die Zeit bis zur Delaminierung ermittelt wird.

Für den technischen Einsatz ist eine ausreichende Lagerstabilität der Basismaterialien eine weitere wesentliche Voraussetzung. Dies gilt vor allem für Prepregs für die Herstellung von Multilayer-Leiterplatten. Dabei werden spezielle kupferkaschierte Innenlagen mit Prepregs sowie mit Kupferfolien verpreßt. Für Multilayer-Leiterplatten mit optimaler interlaminarer Haftung und damit einer Lötbadbeständigkeit, die ausreicht, um IR-Lötprozesse ohne Gefahr der Zerstörung durch Delamination zu überstehen, ist eine genau angepaßte Reaktivität sowie ein optimales Fließverhalten beim Preßvorgang Voraussetzung. Diese Verarbeitungseigenschaften werden beim Halbzeugfabrikanten eingestellt. Um zu gewährleisten, daß bei der Herstellung der Multilayer-Leiterplatten die Verarbeitungseigenschaften noch gegeben sind, wird für Prepregs eine Lagerstabilität von > 3 Monaten gefordert. Innerhalb dieser Zeit darf sich die Reaktivität um maximal 10 % ändern. Bei halogenfrei flammwidrigen Leiterplatten-Basismaterialien ist diese Forderung bislang nur schwer zu erfüllen. So kann durch Maßnahmen zum Einbau von organischen Phosphorkomponenten sowie zur Verbesserung der interlaminaren Haftung und der Lötbadbeständigkeit die Lagerstabilität von Prepregs beeinträchtigt werden.

Aufgabe der Erfindung ist es, technisch einfache und damit kostengünstig zugängliche Epoxidharzmischungen anzugeben, die vergleichbar den im technischen Einsatz befindlichen Epoxidharzen verarbeitbar und - aufgrund der anforderungsgemäßen Lagerstabilität - zur Herstellung von Prepregs und Laminaten für die Multilayertechnik geeignet sind, welche - ohne Halogen - schwerbrennbare, d.h. nach UL 94 V-Spezifikation einstufbare Formstoffe ergeben und gleichzeitig eine so hohe Lötbadbeständigkeit aufweisen, daß IR-Lötprozesse ohne Delamination möglich sind.

Dies wird erfindungsgemäß dadurch erreicht, daß die Epoxidharzmischungen folgende Komponenten enthalten:
- ein phosphormodifiziertes Epoxidharz mit einem Epoxidwert von 0,02 bis 1 mol/100 g, aufgebaut aus Struktureinheiten, die sich ableiten
   (A) von Polyepoxidverbindungen mit mindestens zwei Epoxidgruppen pro Molekül und
   (B) von Phosphinsäureanhydriden, Phosphonsäureanhydriden oder Phosphonsäurehalbestern;
- Dicyandiamid und/oder ein aromatisches Amin folgender Struktur als Härter: 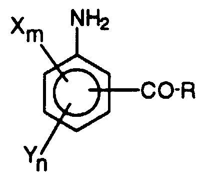 wobei folgendes gilt:
   X ist ein H-Atom und Y eine Alkylgruppe mit 1 bis 3 C-Atomen und m bzw. n bedeutet eine ganze Zahl von 0 bis 4 mit der Maßgabe: m + n = 4,
   R ist eine OH- oder NR¹R²-Gruppe, wobei die Reste R¹ und R² - unabhängig voneinander - ein H-Atom, eine Alkylgruppe mit 1 bis 3 C-Atomen oder eine Aralkylgruppe bedeuten oder einer der Reste R¹ und R² diese Bedeutung hat und der andere Rest eine NR³R⁴-Gruppe ist, mit R³ bzw. R⁴ = H oder Alkyl mit 1 bis 3 C-Atomen, oder R¹ und R² zusammen mit dem N-Atom eine heterocyclische Gruppierung bilden;
- einen aminischen Härtungsbeschleuniger.

Die in den Epoxidharzmischungen nach der Erfindung enthaltenen phosphormodifizierten Epoxidharze werden durch Umsetzung von handelsüblichen Polyepoxidharzen (Polyglycidylharzen) mit folgenden Phosphorverbindungen hergestellt:
- Phosphinsäureanhydride: Anhydride von Phosphinsäuren mit Alkyl-, Alkenyl-, Cycloalkyl-, Aryl- oder Aralkylresten; beispielhaft seien genannt: Dimethylphosphinsäureanhydrid, Methylethylphosphinsäureanhydrid, Diethylphosphinsäureanhydrid, Dipropylphosphinsäureanhydrid, Ethylphenylphosphinsäureanhydrid und Diphenylphosphinsäureanhydrid;
- Bis-phosphinsäureanhydride: Anhydride von Bis-phosphinsäuren, insbesondere von Alkan-bis-phosphinsäuren mit 1 bis 10 Kohlenstoffatomen in der Alkangruppierung; beispielhaft seien genannt: Methan-1,1-bis-methylphosphinsäureanhydrid, Ethan-1,2-bis-methylphosphinsäureanhydrid, Ethan-1,2-bis-phenylphosphinsäureanhydrid und Butan-1,4-bis-methylphosphinsäureanhydrid;
- Phosphonsäureanhydride: Anhydride von Phosphonsäuren mit Alkyl-, Alkenyl-, Cycloalkyl-, Aryl- oder Aralkylresten; beispielhaft seien genannt: Methanphosphonsäureanhydrid, Ethanphosphonsäureanhydrid, Propanphosphonsäureanhydrid, Hexanphosphonsäureanhydrid und Benzolphosphonsäureanhydrid;
- Phosphonsäurehalbester: bevorzugt eingesetzt werden Halbester, d.h. Monoester, von Phosphonsäuren mit Alkylresten (vorzugsweise mit 1 bis 6 Kohlenstoffatomen) oder mit Arylresten (insbesondere Benzolphosphonsäure) mit aliphatischen Alkoholen, insbesondere niedrig siedenden aliphatischen Alkoholen, wie Methanol und Ethanol;
   beispielhaft seien genannt: Methanphosphonsäuremonomethylester, Propanphosphonsäuremonoethylester und Benzolphosphonsäuremonomethylester;
   Phosphonsäurehalbester können durch partielle Hydrolyse der entsprechenden Phosphonsäurediester, insbesondere mittels Natronlauge, oder durch partielle Veresterung der freien Phosphonsäuren mit dem entsprechenden Alkohol hergestellt werden.

Die Herstellung von phosphormodifizierten Epoxidharzen der genannten Art ist auch in den deutschen Offenlegungsschriften 43 08 184 und 43 08 185 beschrieben.

Zur Herstellung der phosphormodifizierten Epoxidharze können generell sowohl aliphatische als auch aromatische Glycidylverbindungen sowie deren Mischungen verwendet werden. Bevorzugt werden Bisphenol-A-diglycidylether, Bisphenol-F-diglycidylether, Polyglycidylether von Phenol/Formaldehyd- und Kresol/Formaldehyd-Novolaken, Diglycidylester von Phthal-, Isophthal-, Terephthal- und Tetrahydrophthalsäure sowie Mischungen aus diesen Epoxidharzen eingesetzt. Weitere verwendbare Polyepoxide sind im "Handbook of Epoxy Resins" von Henry Lee und Kris Neville, McGraw-Hill Book Company 1967, und in der Monographie von Henry Lee "Epoxy Resins", American Chemical Society 1970, beschrieben.

Aus der Palette der möglichen phosphormodifizierten Epoxidharze haben sich für die Herstellung von lötbadbeständigen Elektrolaminaten Phosphonsäure-modifizierte Epoxidharze, wie Methyl-, Ethyl- und Propylphosphonsäure-modifizierte Epoxidharze, als besonders günstig erwiesen, insbesondere mit einem Phosphorgehalt zwischen 2 und 5 Masse-%. Von Vorteil sind weiterhin phosphormodifizierte Epoxidharze mit im Mittel mindestens einer Epoxidfunktionalität, insbesondere solche mit im Mittel mindestens zwei Epoxidfunktionalitäten. Derartige phosphormodifizierte Epoxidharze können durch Umsetzung von Epoxynovolakharzen mit einer Funktionalität von ca. 3 bis 4 mit Phosphonsäureanhydriden hergestellt werden. Die phosphormodifizierten Epoxidharze enthalten 0,5 bis 13 Masse-% Phosphor, vorzugsweise 1 bis 8 Masse-%. Der Phosphorgehalt der Epoxidharzmischungen insgesamt, d.h. der Imprägnierharzmischungen, beträgt 0,5 bis 5 Masse-%, vorzugsweise 1 bis 4 Masse-%.

Die Epoxidharzmischungen nach der Erfindung enthalten vorteilhaft zusätzlich ein phosphorfreies Epoxidharz oder eine glycidylgruppenfreie Verbindung mit phenolischen OH-Gruppen. Das phosphorfreie Epoxidharz wird durch Umsetzung von Bisphenol-A-diglycidylether mit einem Unterschuß an Bisphenol-A erhalten. Die glycidylgruppenfreie Verbindung ist Bisphenol-A, Bisphenol-F oder ein hochmolekulares Phenoxyharz, das durch Kondensation von Bisphenol-A oder Bisphenol-F mit Epichlorhydrin hergestellt wird.

Der Zusatz des phosphorfreien Epoxidharzes dient zur Erzielung bestimmter Eigenschaften der aus den Epoxidharzmischungen hergestellten Laminate. Die Herstellung und der strukturelle Aufbau derartiger Festharze ist in H. Batzer "Polymere Werkstoffe", Band III (Technologie 2), Georg Thieme Verlag, Stuttgart 1984, Seiten 178 ff. beschrieben. Es handelt sich dabei um höhermolekulare, kettenverlängerte Bisphenol-A-diglycidylether mit einem Epoxidwert von 0,22 bis 0,29 Äquivalenten/100 g. In den erfindungsgemäßen Epoxidharzmischungen werden bevorzugt phosphorfreie Epoxidharze mit einem Epoxidwert von 0,22 bis 0,25 Äquivalenten/100 g eingesetzt. Die Viskosität dieser Harze, gemessen bei 120°C, liegt zwischen 300 und 900 mPa·s. Der Gehalt des phosphorfreien Epoxidharzes in der Epoxidharzmischung insgesamt liegt zwischen 0 und 30 Masse-%, bevorzugt zwischen 0 und 10 Masse-%. Die phosphorfreie Epoxidharzkomponente darf nur in einer solchen Menge zugemischt werden, daß die Gesamtmischung noch soviel Phosphor enthält, daß die Forderung nach Flammwidrigkeit gemäß UL 94 V-Spezifikation erfüllt wird. Beim Vorliegen von phosphormodifizierten Epoxidharzen mit hohem Phosphorgehalt kann deshalb mehr phosphorfreies Epoxidharz zugesetzt werden als bei Epoxidharzen mit niedrigem Phosphorgehalt.

Der Zusatz der glycidylgruppenfreien Verbindung mit phenolischen OH-Gruppen erfolgt ebenfalls zur Erzielung bestimmter Eigenschaften. Dazu dienen Bisphenol-A und Bisphenol-F sowie Phenoxyharze. Dies sind lineare Kondensationsprodukte aus Bisphenol-A bzw. Bisphenol-F und Epichlorhydrin in Form hochmolekularer Verbindungen mit einem Molekulargewicht bis zu 30000; der Gehalt an endständigen phenolischen OH-Funktionen ist mit << 1 % sehr gering. Herstellung und Eigenschaften derartiger Phenoxyharze sind bekannt (siehe dazu: "Encyclopedia of Polymer Science and Engineering" (Second Edition), Vol. 6, Seiten 331 und 332, John Wiley & Sons, Inc., 1986). Die Verbindung mit phenolischen OH-Gruppen wird den erfindungsgemäßen Epoxidharzmischungen in Mengen von 0 bis 20 Masse-%, bevorzugt von 0 bis 10 Masse-%, zugesetzt. Auch hierbei ist zu berücksichtigen, daß die glycidylgruppenfreie phenolische Komponente nur bis zu einem Anteil zugemischt werden darf, bei dem die Forderung nach Flammwidrigkeit gemäß UL 94 V-Spezifikation erfüllt wird.

Als Härter wird in den erfindungsgemäßen Epoxidharzmischungen Dicyandiamid und/oder eine zweite Härterkomponente auf der Basis von Aminobenzoesäure eingesetzt. Beispiele für diese Härterkomponente sind 2-Aminobenzoesäure, 4-Aminobenzoesäure, 4-Amino-2-methylbenzoesäure, 4-Aminobenzoesäureamid, 4-Aminobenzoesäuredimethylamid und 4-Aminobenzoesäurehydrazid, wobei 4-Aminobenzoesäure bevorzugt wird. Sowohl Dicyandiamid als auch die zweite Härterkomponente kann zwar alleine zum Einsatz gelangen, vorteilhaft werden jedoch Härtergemische verwendet, wobei Gemische von Dicyandiamid und 4-Aminobenzoesäure bevorzugt sind, insbesondere im Masseverhältnis von 3,5:1 bis 2:1. Werden aus erfindungsgemäßen Epoxidharzmischungen, die ein derartiges Härtergemisch aufweisen, Prepregs und Laminate hergestellt, so wird überraschenderweise ein Optimum in der Kombination der für Prepregs technisch wichtigen Eigenschaften, wie Lötbadbeständigkeit und Lagerstabilität, erhalten.

Der Härter wird in einer solchen Konzentration verwendet, daß das Äquivalentverhältnis zwischen Epoxid-Funktion und aktiver Wasserstoff-Funktion (NH- bzw. COOH-Funktion) in den erfindungsgemäßen Epoxidharzmischungen 1:0,4 bis 1:1,1 beträgt, vorzugsweise 1:0,5 bis 1:0,8. Bei Zusatz einer phenolischen Komponente, die phosphorfrei ist, ist zu berücksichtigen, daß sich die Konzentration der Epoxidgruppen entsprechend dem Gehalt an phenolischen OH-Gruppen verringert. Im allgemeinen beträgt der Gehalt der Harzmischung an Härter 0,5 bis 35 Masse-%, vorzugsweise 2 bis 12 Masse-%.

Aus der JP-OS 58-142913 sind Harzzusammensetzungen bekannt, die Polymaleinimide, Aminobenzoesäureamide und Epoxidharze enthalten. Diese Zusammensetzungen eignen sich zwar zur Herstellung von Glaslaminaten, diese Laminate zeigen jedoch keine UL 94 V-gemäße Flammwidrigkeit ohne Halogen.

Als aminische Härtungsbeschleuniger dienen die üblicherweise bei der Härtung von Epoxidharzen verwendeten tertiären Amine und Imidazole. Als Amine eignen sich beispielsweise Tetramethylethylendiamin, Dimethyloctylamin, Dimethylaminoethanol, Dimethylbenzylamin, 2,4,6-Tris(dimethylaminomethyl)-phenol, N,N'-Tetramethyldiaminodiphenylmethan, N,N'-Dimethylpiperazin, N-Methylmorpholin, N-Methylpiperidin, N-Ethylpyrrolidin, 1,4-Diazabicyclo(2,2,2)-octan und Chinoline. Geeignete Imidazole sind beispielsweise 1-Methylimidazol, 2-Methylimidazol, 1,2-Dimethylimidazol, 1,2,4,5-Tetramethylimidazol, 2-Ethyl-4-methylimidazol, 1-Cyanoethyl-2-phenylimidazol und 1-(4,6-Diamino-s-triazinyl-2-ethyl)-2-phenylimidazol. Der Beschleuniger wird in einer Konzentration von 0,01 bis 2 Masse-%, vorzugsweise 0,05 bis 1 Masse-%, eingesetzt, jeweils bezogen auf die Epoxidharzmischung.

Zur Prepregherstellung werden die verschiedenen Komponenten - getrennt oder zusammen - in kostengünstigen Lösungsmitteln, wie Aceton, Methylethylketon, Ethylacetat, Methoxyethanol, Dimethylformamid und Toluol, oder in Gemischen derartiger Lösungsmittel gelöst, gegebenenfalls zu einer Lösung vereinigt. Die Lösung wird dann auf gängigen Imprägnieranlagen verarbeitet, d.h. zum Tränken von Fasern aus anorganischen oder organischen Materialien, wie Glas, Metall, Mineralien, Kohlenstoff, Aramid, Polyphenylensulfid und Cellulose, sowie von daraus hergestellten Geweben oder Vliesen oder zum Beschichten von Flachenstoffen, wie Folien aus Metallen oder Kunststoffen, eingesetzt. Gegebenenfalls können die Imprägnierlösungen auch weitere die Flammwidrigkeit verbessernde halogenfreie Zusätze enthalten, die zum Teil homogen gelöst bzw. dispergiert sein können. Derartige Zusätze können beispielsweise Melamincyanurate, Melaminphosphate, pulverisiertes Polyetherimid, Polyethersulfon und Polyimid sein.

Zur Herstellung von Prepregs für die Leiterplattentechnik wird überwiegend Glasgewebe eingesetzt. Für Multilayer-Leiterplatten werden insbesondere Prepregs aus Glasgewebetypen mit einem Flächengewicht von 25 bis 200 g/m² eingesetzt. Mit Imprägnierlösungen der vorstehend genannten Art lassen sich auch Prepregs mit geringen Flächengewichten Anforderungsgemäß herstellen. Die imprägnierten oder beschichteten Verstärkungsmaterialien bzw. Einlagerungskomponenten werden bei erhöhter Temperatur getrocknet, wobei einerseits das Lösungsmittel entfernt wird und andererseits eine Vorpolymerisation des Imprägnierharzes erfolgt. Insgesamt ergibt sich auf diese Weise ein außerordentlich günstiges Verhältnis von Aufwand zu erzielbaren Eigenschaften.

Die erhaltenen Beschichtungen und Prepregs sind nicht-klebend und bei Raumtemperatur für die Dauer von drei Monaten und mehr lagerstabil, d.h. sie weisen eine ausreichende Lagerstabilität auf. Sie lassen sich bei Temperaturen bis 220°C zu Verbundwerkstoffen verpressen, die sich durch hohe Glasübergangstemperaturen von bis zu 170°C und durch inhärente Schwerbrennbarkeit auszeichnen. Werden als Einlagerungsmaterial beispielsweise Glasgewebe mit einem Masseanteil von 60 bis 62 %, bezogen auf das Laminat, verwendet, so wird die Brennprüfung nach UL 94 V - ohne Zusatz von Halogenverbindungen oder sonstigen flammhemmenden Zusatzstoffen - selbst bei Prüfkörpern mit einer Wandstärke von 1,6 mm oder sogar 0,8 mm mit einer sicheren V-0-Einstufung bestanden. Dabei erweist es sich als besonders vorteilhaft, daß keine korrosiven oder besonders toxischen Spaltprodukte gebildet werden und die Rauchentwicklung - im Vergleich zu anderen Polymerwerkstoffen, insbesondere zu bromhaltigen Epoxidharz-Formstoffen - stark vermindert ist.

Die aus den erfindungsgemäßen Epoxidharzmischungen hergestellten Laminate zeichnen sich, insbesondere bei Verwendung eines Härtergemisches, durch eine für die Technik attraktive Kombination guter Eigenschaften, wie Kupfer-Haftfestigkeit, interlaminare Haftung, Lötbadbeständigkeit und Lagerstabilität, aus.

Anhand von Ausführungsbeispielen soll die Erfindung noch näher erläutert werden (MT = Masseteile).

### Beispiel 1

### Herstellung von Prepregs

Eine Lösung von A MT Dicyandiamid (Dicy) - in H MT Dimethylformamid (DMF) - wird mit einer Lösung von C MT eines phosphormodifizierten Epoxidharzes (P/EP-Harz) in Form eines Umsetzungsproduktes (Epoxidwert: 0,32 mol/100 g; Phosphorgehalt: 3,8 %) aus einem epoxidierten Novolak (Epoxidwert: 0,56 mol/100 g; mittlere Funktionalität: 3,6) und Propanphosphonsäureanhydrid - in G MT Methylethylketon (MEK) und I MT Ethylacetat (EA) - versetzt; anschließend werden der Harzlösung noch D MT 2-Methylimidazol (MeIm) zugegeben. Mit der dabei erhaltenen Imprägnierharzlösung werden Glasgewebe (Glasgewebetyp 7628; Flächengewicht: 197 g/m²) mittels einer Laborimprägnieranlage kontinuierlich imprägniert und in einer Vertikaltrockenanlage bei Temperaturen von 50 bis 160°C getrocknet. Derart hergestellte Prepregs sind klebfrei. Die Zusammensetzung der Imprägnierharzlösung und die Eigenschaften der Prepregs sind Tabelle 1 zu entnehmen.

### Beispiele 2 bis 5

### Herstellung von Prepregs

Es wird entsprechend Beispiel 1 vorgegangen, die Imprägnierharzlösungen werden jedoch zusätzlich mit B MT 4-Aminobenzoesäure (ABS) und E MT eines Epoxidharzes (EP-Harz), gelöst in J MT Dimethylformamid (DMF), versetzt. Das Epoxidharz (Epoxidwert: 0,25 mol/100 g; Viskosität bei 120°C: 380 mPa·s) wird durch Umsetzung von Bisphenol-A-diglycidylether mit einem Unterschuß an Bisphenol-A hergestellt . Die Zusammensetzung der Imprägnierharzlösungen und die Eigenschaften der Prepregs sind Tabelle 1 zu entnehmen.

### Beispiel 6

### Herstellung von Prepregs

Es wird entsprechend Beispiel 1 vorgegangen, die Imprägnierharzlösung wird jedoch zusätzlich mit B MT 4-Aminobenzoesäure (ABS) und F MT eines Phenoxyharzes (Phen-Harz), gelost in J MT Dimethylformamid (DMF), versetzt. Das Phenoxyharz (Molekulargewicht: 25000 bis 30000; Hydroxylwert: 6 %) ist ein glycidylgruppenfreies, lineares Kondensat aus Bisphenol-A und Epichlorhydrin . Die Zusammensetzung der Imprägnierharzlösung und die Eigenschaften der Prepregs sind Tabelle 1 zu entnehmen.

**Tabelle 1**

| Zusammensetzung der Imprägnierharzlösungen und Eigenschaften der Prepregs | | | | | | | |
|---|---|---|---|---|---|---|---|
| Beispiel Nr. | 1 | 2 | 3 | 4 | 5 | 6 | 7 |
| Komponenten (MT): | | | | | | | |
| A (Dicy) | 4,9 | 3,5 | 3,0 | 3,0 | 2,5 | 3,0 | - |
| B (ABS) | - | 1,0 | 1,5 | 2,0 | 3,0 | 1,5 | 12 |
| C (P/EP-Harz) | 95 | 85 | 86 | 85 | 84 | 86 | 88 |
| D (MeIm) | 0,1 | 0,1 | 0,1 | 0,1 | 0,1 | 0,1 | - |
| E (EP-Harz) | - | 10 | 10 | 10 | 10 | - | - |
| F (Phen-Harz) | - | - | - | - | - | 10 | - |
| G (MEK) | 66 | 70 | 70 | 70 | 70 | 50 | 66 |
| H (DMF) | 29 | 6 | 6 | 6 | 6 | 6 | 30 |
| I (EA) | 5 | 4 | 4 | 4 | 4 | 4 | 4 |
| J (DMF) | - | 20 | 20 | 20 | 20 | 40 | - |
| | | | | | | | |

| Meßwerte: | | | | | | | |
|---|---|---|---|---|---|---|---|
| Restgehalt an | | | | | | | |
| Lösungsmittel (%) | 0,2 | 0,2 | 0,2 | 0,2 | 0,2 | 0,2 | 0,2 |
| Restgelierzeit nach | | | | | | | |
| 3 Monaten (in % vom | | | | | | | |
| Ausgangswert) | 90 | 93 | 90 | 75 | 30 | 60 | geliert |

Die Restgelierzeit wird in der Weise bestimmt, daß von den Prepregs mechanisch abgelöstes, glasfaserfreies Imprägnierharz (0,2 bis 0,3 g) auf eine auf 170°C vorgewärmte Heizplatte aufgebracht wird. Nach ca. 30 s wird die aufgeschmolzene Harzprobe mit einem Glas- oder Holzstab gleichmäßig gerührt. Die Viskositätsänderung wird durch Ziehen von etwa 50 mm langen Fäden aus der Schmelze beobachtet. Die Gelierung ist eingetreten, wenn sich keine Fäden mehr ziehen lassen. Die mit einer Stoppuhr ermittelte Zeitspanne (in s) vom Aufbringen des Harzes auf die Heizplatte bis zum vorzeitigen Abreißen der Fäden ist die Gelierzeit.

### Beispiel 7

### Vergleichsversuch

Es wird entsprechend Beispiel 1 vorgegangen, die Imprägnierharzlösung wird jedoch - anstelle von A MT Dicyandiamid (Dicy) - mit B MT 4-Aminobenzoesäure (ABS), gelost in H MT Dimethylformamid (DMF), versetzt; außerdem wird kein Härtungsbeschleuniger (D) zugegeben. Die Zusammensetzung der Imprägnierharzlösung und die Eigenschaften der Prepregs sind Tabelle 1 zu entnehmen.

### Beispiele 8 bis 14

### Herstellung und Prüfung von Laminaten

Je acht der nach den Beispielen 1 bis 7 hergestellten Prepregs (Glasgewebetyp 7628; Flächengewicht: 197 g/m²), beidseitig kaschiert mit einer 35 µm Cu-Folie, werden in einer Presse bei 175°C und 20 bar verpreßt. Die 1,5 bis 1,6 mm dicken Laminate werden nach 40 min aus der Presse entfernt und anschließend 2 h bei 175°C nachgetempert. An den auf diese Weise erhaltenen Körpern wird - mittels dynamischmechanischer Analyse (DMTA) - die Glasübergangstemperatur T_{G}, die Brennbarkeit nach UL 94 V, das Haftvermögen der Kupferfolie, der Measling-Test, der High-Pressure-Cooker-Test und die Lötbadbeständigkeit bestimmt. Die erhaltenen Werte sind Tabelle 2 zu entnehmen.

**Tabelle 2**

| Eigenschaften der Laminate | | | | | | | |
|---|---|---|---|---|---|---|---|
| Beispiel Nr. | 8 | 9 | 10 | 11 | 12 | 13 | 14 |
| Prepregs entsprechend Beispiel Nr. | 1 | 2 | 3 | 4 | 5 | 6 | 7 |
| Meßwerte: | | | | | | | |
| T_{G}(°C) | 170 | 168 | 161 | 156 | 160 | 155 | 160 |
| mittlere Brenndauer nach UL 94 V (s) | 2,7 | 4,7 | 4,9 | 4,7 | 4,8 | 4,4 | 3,9 |
| Einstufung | V-0 | V-0 | V-0 | V-0 | V-0 | V-0 | V-0 |
| Haftvermögen der Cu- Folie bei RT (N/mm) | 48 | 52 | 53 | 49 | 49 | 51 | 47 |
| Measling-Test (LT26) | + | + | + | + | + | + | + |
| High-Pressure-Cooker-Test (s) | 12 | 18 | >20 | >20 | >20 | >20 | >20 |
| Lötbadbeständigkeit bei 288°C (s) | 50 | 115 | 115 | 125 | 144 | 95 | >600 |

Die an den Laminaten durchgeführten Tests verlaufen folgendermaßen:
- Haftvermögen der Kupferkaschierung
   Ein 25 mm breiter und 100 mm langer Streifen der Kupferfolie wird auf 20 mm Länge vom Glashartgewebe gelöst und mittels einer geeigneten Vorrichtung mit einer Abzugsgeschwindigkeit von 50 mm/min senkrecht abgezogen; gemessen wird die hierzu erforderliche Kraft F (N).
- Measling-Test
   Die Prüfung erfolgt an Probekörpern ohne Kupferkaschierung (Größe: 20 mm x 100 mm). Die Probekörper werden 3 min in eine 65°C heiße LT26-Lösung (Zusammensetzung: 850 ml entionisiertes H₂O, 50 ml HCl p.a., 100 g SnCl₂ · 2 H₂O, 50 g Thioharnstoff) getaucht, mit fließendem Wasser abgespült und anschließend 20 min in kochendes Wasser gelegt. Nach Trocknung an der Luft (2 bis 3 min) wird die Probe 10 s in ein 260°C heißes Lötbad getaucht. Das Laminat darf dabei nicht delaminieren.
- High-Pressure-Cooker-Test
   Zwei Probekörper der Größe 50 mm x 50 mm werden 2 h in einer Wasserdampfatmosphäre mit einer Temperatur von 120 bis 125°C im Hochdruckautoklav gelagert. Nachfolgend werden die getrockneten Proben innerhalb von 2 min für 20 s auf ein 260 C heißes Lötbad gelegt. Die Probekörper dürfen dabei nicht delaminieren.
- Lötbadbeständigkeit
   Die Prüfung erfolgt nach DIN IEC 259 unter Verwendung eines Lotbades nach Abschnitt 3.7.2.3. Es werden Probekörper der Größe 25 mm x 100 mm verwendet, die in ein Lötbad mit einer Temperatur von 288°C eingetaucht werden, und es wird die Zeit bis zur Entstehung von Delaminierungen oder Blasen gemessen.

## Patentansprüche

1. Epoxidharzmischungen zur Herstellung von Prepregs und Verbundwerkstoffen, **dadurch gekennzeichnet,** daß sie folgende Komponenten enthalten:
- ein phosphormodifiziertes Epoxidharz mit einem Epoxidwert von 0,02 bis 1 mol/100 g, aufgebaut aus Struktureinheiten, die sich ableiten
(A) von Polyepoxidverbindungen mit mindestens zwei Epoxidgruppen pro Molekül und
(B) von Phosphinsäureanhydriden, Phosphonsäureanhydriden oder Phosphonsäurehalbestern;
- Dicyandiamid und/oder ein aromatisches Amin folgender Struktur als Härter: 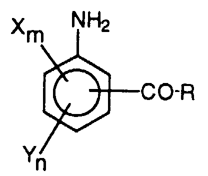 wobei folgendes gilt:
X ist ein H-Atom und Y eine Alkylgruppe mit 1 bis 3 C-Atomen und m bzw. n bedeutet eine ganze Zahl von 0 bis 4 mit der Maßgabe: m + n = 4,
R ist eine OH- oder NR¹R²-Gruppe, wobei die Reste R¹ und R² - unabhängig voneinander - ein H-Atom, eine Alkylgruppe mit 1 bis 3 C-Atomen oder eine Aralkylgruppe bedeuten oder einer der Reste R¹ und R² diese Bedeutung hat und der andere Rest eine NR³R⁴-Gruppe ist, mit R³ bzw. R⁴ = H oder Alkyl mit 1 bis 3 C-Atomen, oder R¹ und R² zusammen mit dem N-Atom eine heterocyclische Gruppierung bilden;
- einen aminischen Härtungsbeschleuniger.

2. Epoxidharzmischungen nach Anspruch 1, **dadurch gekennzeichnet,** daß sie ein phosphorfreies Epoxidharz, hergestellt durch Umsetzung von Bisphenol-A-diglycidylether mit einem Unterschuß an Bisphenol-A, enthalten oder eine glycidylgruppenfreie Verbindung mit phenolischen OH-Gruppen in Form von Bisphenol-A, Bisphenol-F oder einem durch Kondensation von Bisphenol-A oder Bisphenol-F mit Epichlorhydrin erhaltenen hochmolekularen Phenoxyharz.

3. Epoxidharzmischungen nach Anspruch 2, **dadurch gekennzeichnet,** daß der Anteil des phosphorfreien Epoxidharzes in der Harzmischung bis zu 30 Masse-% beträgt, vorzugsweise bis zu 10 Masse-%.

4. Epoxidharzmischungen nach Anspruch 2 oder 3, **dadurch gekennzeichnet,** daß der Anteil der glycidylgruppenfreien Verbindung in der Harzmischung bis zu 20 Masse-% beträgt, vorzugsweise bis zu 10 Masse-%.

5. Epoxidharzmischungen nach einem oder mehreren der Ansprüche 1 bis 4, **dadurch gekennzeichnet,** daß der Phosphorgehalt 0,5 bis 5 Masse-% beträgt, vorzugsweise 1 bis 4 Masse-%, jeweils bezogen auf die Harzmischung.

6. Epoxidharzmischungen nach einem oder mehreren der Ansprüche 1 bis 5, **dadurch gekennzeichnet,** daß das Äquivalentverhältnis zwischen Epoxid-Funktionen und NH-Funktionen 1:0,4 bis 1:1,1 beträgt, vorzugsweise 1:0,5 bis 1:0,8.

7. Epoxidharzmischungen nach einem oder mehreren der Ansprüche 1 bis 6, **dadurch gekennzeichnet,** daß der Gehalt der Harzmischung an Härter 0,5 bis 35 Masse-% beträgt, vorzugsweise 2 bis 12 Masse-%.

8. Epoxidharzmischungen nach einem oder mehreren der Ansprüche 1 bis 7, **dadurch gekennzeichnet,** daß der Härter 2-Aminobenzoesäure, 4-Aminobenzoesäure, 4-Amino-2-methylbenzoesäure, 4-Aminobenzoesäureamid, 4-Aminobenzoesäuredimethylamid oder 4-Aminobenzoesäurehydrazid ist und insbesondere ein Gemisch aus Dicyandiamid und 4-Aminobenzoesäure.

9. Prepregs und Verbundwerkstoffe auf der Basis von anorganischen oder organischen Verstärkungsmaterialien in Form von Fasern, Vliesen oder Geweben bzw. von Flachenstoffen, hergestellt aus Epoxidharzmischungen nach einem oder mehreren der Ansprüche 1 bis 8.

10. Leiterplatten aus Prepregs, hergestellt aus Glasfasergewebe und Epoxidharzmischungen nach einem oder mehreren der Ansprüche 1 bis 8.

## Claims

1. Epoxy resin mixtures for producing prepregs and composites, characterised in that they contain the following components:
- a phosphorus-modified epoxy resin with an epoxy value of 0.02 to 1 mol/100 g, made up of structural units derived from
(a) polyepoxy compounds with at least two epoxy groups per molecule, and
(b) phosphinic acid anhydrides, phosphonic acid anhydrides or phosphonic acid half-esters;
- dicyandiamide and/or an aromatic amine of the following structure as the hardener: 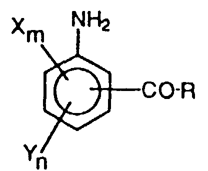 where
X is a hydrogen atom and Y is an alkyl group with 1 to 3 C atoms, and m and n denote an integer from 0 to 4 with the proviso that m + n = 4,
R is an OH or NR¹R² group, where the R¹ and R² groups, independently of each other, denote a hydrogen atom, an alkyl group with 1 to 3 C atoms or an aralkyl group, or one of the R¹ and R² groups has this meaning and the other group is an NR³R⁴ group, where R³ and R⁴ = H or an alkyl group with 1 to 3 C atoms, or R¹ and R² together with the nitrogen may form a heterocyclic group;
- an amino hardening accelerator.

2. Epoxy resin mixtures according to claim 1, characterised in that they contain a phosphorus-free epoxy resin prepared by reacting bisphenol A diglycidyl ether with a substoichiometric quantity of bisphenol A, or a glycidyl group-free compound with phenolic OH groups in the form of bisphenol A, bisphenol F or a high-molecular phenoxy resin obtained by condensation of bisphenol A or bisphenol F with epichlorhydrin.

3. Epoxy resin mixtures according claim 2, characterised in that the phosphorus-free epoxy resin content in the resin mixture is up to 30 wt%, preferably up to 10 wt%.

4. Epoxy resin mixtures according to claim 2 or claim 3, characterised in that the amount of the glycidyl group-free compound in the resin mixture is up to 20 wt%, preferably up to 10 wt%.

5. Epoxy resin mixtures according to one or more of claims 1 to 4, characterised in that the phosphorus content is 0.5 to 5 wt%, preferably 1 to 4 wt%, each based on the resin mixture.

6. Epoxy resin mixtures according to one or more of claims 1 to 5, characterised in that the equivalent ratio between epoxy functions and NH functions is 1:0.4 to 1:1.1, preferably 1:0.5 to 1:0.8.

7. Epoxy resin mixtures according to one or more of claims 1 to 6, characterised in that the hardener content of the resin mixture is 0.5 to 35 wt%, preferably 2 to 12 wt%.

8. Epoxy resin mixtures according to one or more of claims 1 to 7, characterised in that the hardener is 2-aminobenzoic acid, 4-aminobenzoic acid, 4-amino-2 methylbenzoic acid, 4-aminobenzoic acid amide, 4-aminobenzoic acid dimethyl amide or 4-aminobenzoic acid hydrazide, in particular a mixture of dicyandiamide and 4-aminobenzoic acid.

9. Prepregs and composites based on organic or inorganic reinforcing materials in the form of fibres, wovens or nonwovens or flat shaped articles, produced from epoxy resin mixtures according to one or more of claims 1 to 8.

10. Circuit boards made of prepregs, produced from glass fibre fabrics and epoxy resin mixtures according to one or more of claims 1 to 8.

## Revendications

1. Mélanges de résine époxy pour la production de préimprégnés et de matériaux composites, caractérisés en ce qu'ils contiennent les composants suivants :
- une résine époxy modifiée par du phosphore, avec un indice époxy de 0,02 à 1 mole/100 g, constituée d'unités structurales dérivées
(A) de composés polyépoxy avec au moins deux groupes époxy par molécule et
(B) d'anhydrides d'acides phosphiniques, d'anhydrides d'acides phosphoniques ou de semi-esters d'acides phosphoniques ;
- du dicyanodiamide et/ou une amine aromatique présentant la structure suivante à titre de durcisseur : 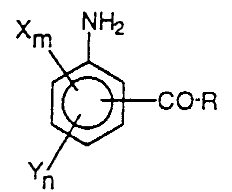 où vaut ce qui suit :
X représente un atome H et Y représente un groupe alkyle avec 1 à 3 atomes C et m, respectivement n, signifie un nombre entier de 0 à 4 sous condition que m + n = 4,
R représente un groupe OH ou NR¹R², les résidus R¹ et R² représentant - indépendamment l'un de l'autre - un atome H, un groupe alkyle avec 1 à 3 atomes C ou un groupe arylalkyle, ou bien un des résidus R¹ et R² a cette signification et l'autre résidu représente un groupe NR³R⁴ avec R³, respectivement R⁴ = H ou un groupe alkyle avec 1 à 3 atomes C, ou bien R¹ et R² forment ensemble avec l'atome N un groupement hétérocyclique ;
- un accélérateur de durcissement amine.

2. Mélanges de résine époxy selon la revendication 1, caractérisés en ce qu'ils contiennent une résine époxy exempte de phosphore, préparée par réaction d'éther diglycidylique de bisphénol A avec une quantité inférieure à la stoechiométrie de bisphénol A, ou un composé exempt de groupes glycidyliques avec des groupes OH phénoliques sous forme de bisphénol A, de bisphénol F ou une résine phénoxy de poids moléculaire élevé obtenue par condensation de bisphénol A ou de bisphénol F avec l'épichlorhydrine.

3. Mélanges de résine époxy selon la revendication 2, caractérisés en ce que la fraction de la résine époxy exempte de phosphore dans le mélange de résine vaut jusqu'à 30 % massiques, de préférence jusqu'à 10 % massiques.

4. Mélanges de résine époxy selon la revendication 2 ou 3, caractérisés en ce que la fraction du composé exempt de groupes glycidyliques dans le mélange de résine vaut jusqu'à 20 % massiques, de préférence jusqu'à 10 % massiques.

5. Mélanges de résine époxy selon une ou plusieurs des revendications 1 à 4, caractérisés en ce que la teneur en phosphore vaut 0,5 à 5 % massiques, de préférence 1 à 4 % massiques, respectivement par rapport au mélange de résine.

6. Mélanges de résine époxy selon une ou plusieurs des revendications 1 à 5, caractérisés en ce que le rapport d'équivalence entre les fonctions époxy et les fonctions NH vaut 1 : 0,4 à 1 : 1,1, de préférence 1 : 0,5 à 1 : 0,8.

7. Mélanges de résine époxy selon une ou plusieurs des revendications 1 à 6, caractérisés en ce que la teneur en durcisseur du mélange de résine vaut de 0,5 à 35 % massiques, de préférence 2 à 12 % massiques.

8. Mélanges de résine époxy selon une ou plusieurs des revendications 1 à 7, caractérisés en ce que le durcisseur est l'acide 2-aminobenzoïque, l'acide 4-aminobenzoïque, l'acide 4-amino-2-méthylbenzoïque, l'amide de l'acide 4-aminobenzoïque, l'amide diméthylique de l'acide 4-aminobenzoïque ou l'hydrazide de l'acide 4-aminobenzoïque et en particulier un mélange de dicyanodiamide et d'acide 4-aminobenzoïque.

9. Préimprégnés et matériaux composites sur base de matériaux de renforcement inorganiques ou organiques sous forme de fibres, de non-tissés ou de tissus, respectivement de matériaux plans, fabriqués à partir de mélanges de résine époxy selon une ou plusieurs des revendications 1 à 8.

10. Cartes de circuits imprimés constituées de préimprégnés, fabriqués de tissus de fibres de verre et de mélanges de résine époxy selon une ou plusieurs des revendications 1 à 8.
